# EUROPEAN PATENT APPLICATION

(11) **EP 1 517 378 A2**
(43) Date of publication of application: **23.03.2005**
(21) Application number: 04255683.7
(22) Date of filing: 17.09.2004
(51) Int. Cl.: H01L 31/032, H01L 31/0336, H01L 31/18

(54) **Semiconductor film, method for manufacturing the semiconductor film, solar cell using the semiconductor film and method for manufacturing the solar cell**

(30) Priority: 17.09.2003 JP 2003324961
(71) Applicant: MATSUSHITA ELECTRIC INDUSTRIAL CO., LTD., Kadoma-shi, Osaka 571-8501 (JP)
(72) Inventor: Negami, Takayuki, Hirakata-shi Osaka 573-0164 (JP); Satoh, Takuya, Yawata-shi Kyoto 614-8297 (JP); Hashimoto, Yasuhiro, Soraku-gun Kyoto 619-0243 (JP)
(74) Representative: Tothill, John Paul

(57) **Abstract**

A semiconductor film has a composition in which a Group Ia element and a Group Vb element are added to a compound semiconductor with a chalcopyrite structure containing a Group Ib element, a Group IIIb element and a Group VIb element. This allows the provision of a semiconductor film whose carrier density can be controlled effectively. A solar cell (1) of the present invention includes: a substrate (11) and the semiconductor film of the present invention that is provided as a light-absorption layer (13) on the substrate (11). With this configuration, a light-absorption layer whose carrier density can be controlled effectively can be provided, so that a solar cell having a high energy conversion efficiency can be provided.

## Description

The present invention relates to a semiconductor film, a method for manufacturing the semiconductor film, a solar cell using the semiconductor film and a method for manufacturing the solar cell.

Solar cells using CuInSe₂ (hereinafter referred to as CIS) and Cu(In, Ga)Se₂ (hereinafter referred to as CIGS) as a light-absorption layer have an advantage of showing a high energy conversion efficiency and being free from a deterioration in the efficiency caused by the irradiation with light, where the CuInSe₂ is a compound semiconductor (chalcopyrite structured semiconductor) containing a Group Ib element, a Group IIIb element and a Group VIb element and the Cu(In, Ga)Se₂ is a solid solution of CIS with Ga.

Generally speaking, in order to enhance the efficiency of a solar cell, it is important to control the carrier density. For instance, it is known that, in a solar cell using a CIGS film that is a semiconductor film as a light-absorption layer, Na as a Group Ia element serves to reduce defects, which results in an increase in carrier density. Then, as technology for doping Na intentionally, methods have been proposed in which a Na-containing layer is formed, on which a CIGS film is formed (See JP H08(1996)-102546 A, H08(1996)-222750 A and JP H10(1998)-512096A, for example). According to this method, the addition of Na increases the carrier density of the CIGS film, so that a solar cell with a high energy conversion efficiency can be provided.

As a method for increasing a carrier density without resorting to the addition of Na, another method has been proposed in which Se as a Group VIb element that is contained in a CIS film is replaced partially with P, Sb or Bi as a Group Vb element by an ion implantation method (See S. Kohiki et al, "Valence Manipulation and Homojunction Diode Fabrication of Chalcopyrite Structure Cu-In-Se Thin Films", Thin Solid Films, Vol. 226, 1993, pp 149 to 155, for example). Furthermore, a doping method using a nitrogen ion as a Group Vb element (See H05(1993)-029361 A, for example) or a method in which a CIGS film is manufactured using a precursor for semiconductor thin film formation to which Group Vb elements have been doped (See JP H10(1998)-150212 A, for example) also have been proposed.

According to the method of forming a Na-containing layer, followed by the formation of a CIGS film thereon, however, a sufficient increase in carrier density cannot be obtained, which means a low open circuit voltage of a solar cell, thus resulting in a deterioration in the conversion efficiency in some cases. In the case where the doping amount of Na is increased by increasing a film thickness of the Na-containing layer, the crystal growth of the CIGS film is inhibited, which results in an increase in crystal defects in some cases. In this way, the method of forming a Na-containing layer has a limit on the control of the carrier density.

Meanwhile, according to the method of doping a Group Vb element, since the activation yield of a Group Vb dopant is low in a CIGS film, large amounts of elements need to be doped in order to increase the carrier density. In this case, there is a problem that the carrier density does not increase in proportion to the doped amount, and therefore there still is a limit on the control of the carrier density.

Therefore, with the foregoing in mind, it is an object of the present invention to provide a semiconductor film whose carrier density is controlled effectively, a method for manufacturing the semiconductor film, a solar cell using the semiconductor film and a method for manufacturing the solar cell.

A semiconductor film of the present invention has a composition in which a Group Ia element and a Group Vb element are added to a compound semiconductor with a chalcopyrite structure containing a Group Ib element, a Group IIIb element and a Group VIb element.

A solar cell of the present invention includes: a substrate; and the above semiconductor film that is provided on the substrate as a light-absorption layer.

A first method for manufacturing a semiconductor film of the present invention includes the steps of: (i) forming a first thin film containing a Group Ia element and a Group Vb element; and (ii) supplying a Group Ib element, a Group IIIb element and a Group VIb element on the first thin film so as to form the semiconductor film having a composition in which the Group Ia element and the Group Vb element are added to a compound semiconductor with a chalcopyrite structure containing the Group Ib element, the Group IIIb element and the Group VIb element.

A second method for manufacturing a semiconductor film of the present invention includes the steps of: (i) forming a fourth thin film containing a Group Ib element, a Group IIIb element and a Group VIb element; and (ii) supplying a Group Ia element and a Group Vb element on the fourth thin film so as to form the semiconductor film having a composition in which the Group Ia element and the Group Vb element are added to a compound semiconductor with a chalcopyrite structure containing the Group Ib element, the Group IIIb element and the Group VIb element.

A third method for manufacturing a semiconductor film of the present invention includes the step of: when forming a compound semiconductor containing a Group Ib element, a Group IIIb element and a Group VIb element, supplying a Group Ia element and a Group Vb element thereto at the same time so as to form the semiconductor film having a composition in which the Group Ia element and the Group Vb element are added to a compound semiconductor with a chalcopyrite structure containing the Group Ib element, the Group IIIb element and the Group VIb element.

A method for manufacturing a solar cell of the present invention includes the steps of: preparing a substrate; and providing a semiconductor film as a light-absorption layer on the substrate according to any one of the above-described semiconductor film manufacturing methods.

The semiconductor film of the present invention has a composition in which a Group Ia element and a Group Vb element are added to a compound semiconductor with a chalcopyrite structure containing a Group Ib element, a Group IIIb element and a Group VIb element. The doping of the Group Ia element to the compound semiconductor containing the Group Ib element, the Group IIIb element and the Group VIb element allows a reduction in crystal defects in the compound semiconductor containing the Group Ib element, the Group IIIb element and the Group VIb element, and therefore a donor density decreases and a density of acceptors, which tend to be cancelled out with the donors, increases. Furthermore, since the Group Vb element also is doped, the acceptor density can be increased directly. Thereby, a semiconductor film whose carrier density is controlled effectively can be provided. Note here that Group elements are represented in this specification so as to comply with the specifications of IUPAC (1970). According to the specifications of IUPAC (1989), the above Group Ib, Group IIIb and Group VIb correspond to Group 11, Group 13 and Group 16, respectively, and the above Group Ia and Group Vb correspond to Group 1 and Group 15, respectively.

In the semiconductor film of the present invention, a content of atoms of the Group Ia element in the semiconductor film may range from 0.005 to 5 atom%, and a content of atoms of the Group Vb element in the semiconductor film may range from 0.001 to 1 atom%. This configuration can increase the carrier density of the semiconductor film effectively.

In the semiconductor film of the present invention, the Group Ia element may be at least one element selected from the group consisting of Li, Na and K and the Group Vb element may be at least one element selected from the group consisting of N and P.

In the semiconductor film of the present invention, the Group Ib element may be Cu, the Group IIIb element may be at least one element selected from the group consisting of In and Ga, and the Group VIb element may be at least one element selected from the group consisting of Se and S.

The solar cell of the present invention includes: a substrate; and the above semiconductor film that is provided on the substrate as a light-absorption layer. With the use of the semiconductor film whose carrier density has been controlled effectively as the light-absorption layer, a solar cell having a high energy conversion efficiency can be provided.

The solar cell of the present invention further may include an electrode layer that is provided on at least one of an upper surface and a lower surface of the light-absorption layer. The light-absorption layer may include a first light-absorption layer disposed on a side of the electrode layer and a second light-absorption layer disposed so as to sandwich the first light-absorption layer with the electrode layer, and a content of atoms of a Group Ia element and a Group Vb element in the first light-absorption layer may be twice or more a content of atoms of a Group Ia element and a Group Vb element in the second light-absorption layer. With this configuration, the carrier density of the first light-absorption layer disposed on the electrode layer side is larger than the carrier density of the second light-absorption layer, and therefore an electric field is generated on the electrode layer side because of a difference in Fermi level. This electric field (barrier) reflects carriers generated due to the light absorption and traveling toward the electrode layer side, so that recombination does not occur in the vicinity of the electrode layer, and therefore the photoelectric current extracted can be increased. Furthermore, in the solar cell of the present invention, the first light-absorption layer may have a film thickness of 10 to 300 nm. This allows more effective extraction of the photoelectric current.

The first method for manufacturing a semiconductor film of the present invention includes the steps of:(i) forming a first thin film containing a Group Ia element and a Group Vb element; and (ii) supplying a Group Ib element, a Group IIIb element and a Group VIb element on the first thin film so as to form the semiconductor film having a composition in which the Group Ia element and the Group Vb element are added to a compound semiconductor with a chalcopyrite structure containing the Group Ib element, the Group IIIb element and the Group VIb element. With this method, a semiconductor film can be formed in which a Group Ia element and a Group Vb element are added to a compound semiconductor containing a Group Ib element, a Group IIIb element and a Group VIb element, and therefore a semiconductor film whose carrier density is controlled effectively can be provided.

Specifically, the above step (ii) of the first method for manufacturing a semiconductor film may be any one of the following 1) to 3):
1) including the step of forming the semiconductor film by depositing the Group Ib element, the Group IIIb element and the Group VIb element on the first thin film, while applying heat to the first thin film;
2) including the steps of:
   (ii-A) forming a second thin film containing the Group Ib element and the Group IIIb element on the first thin film; and
   (ii-B) conducting a heat treatment on the first thin film and the second thin film in an atmosphere containing the Group VIb element so as to form the semiconductor film;
3) including the steps of:
   (ii-a) forming a third thin film containing the Group Ib element, the Group IIIb element and the Group VIb element on the first thin film, and
   (ii-b) conducting a heat treatment on the first thin film and the third thin film so as to form the semiconductor film.

In the first method for manufacturing a semiconductor film of the present invention, the first thin film further may contain a Group VIb element. This allows the stable configuration to be maintained even when the first thin film contacts with the air and the like.

In the first method for manufacturing a semiconductor film of the present invention, the step (i) may include: the step of forming the first thin film by sputtering using a sintered body containing at least the Group Ia element and the Group Vb element as a target; or the step of forming the first thin film by evaporation using a sintered body containing at least the Group Ia element and the Group Vb element as an evaporation source. This allows the formation of a first thin film having excellent reproducibility of film thickness. Furthermore, this sintered body may contain at least one selected from the group consisting of lithium phosphate and sodium phosphate. These compounds enable the stable supply of a Group Ia element and a Group Vb element with favorable controllability.

The second method for manufacturing a semiconductor film of the present invention includes the steps of: (i) forming a fourth thin film containing a Group Ib element, a Group IIIb element and a Group VIb element; and (ii) supplying a Group Ia element and a Group Vb element on the fourth thin film so as to form the semiconductor film having a composition in which the Group Ia element and the Group Vb element are added to a compound semiconductor with a chalcopyrite structure containing the Group Ib element, the Group IIIb element and the Group VIb element. With this method, a semiconductor film can be formed in which a Group Ia element and a Group Vb element are added to a compound semiconductor containing a Group Ib element, a Group IIIb element and a Group VIb element, and therefore a semiconductor film whose carrier density is controlled effectively can be provided.

Specifically, the above step (ii) of the second method for manufacturing a semiconductor film may be the following 1) or 2):
1) including the step of depositing the Group Ia element and the Group Vb element on the fourth thin film, while applying heat to the fourth thin film so as to form the semiconductor film.
2) including the steps of:
   (ii-A) forming a fifth thin film containing the Group Ia element and the Group Vb element on the fourth thin film; and
   (ii-B) conducting a heat treatment on the fourth thin film and the fifth thin film so as to form the semiconductor film.

In the second method for manufacturing a semiconductor film of the present invention, the fifth thin film further may contain a Group VIb element. This allows the stable configuration to be maintained even when the fifth thin film contacts with the air and the like.

In the second method for manufacturing a semiconductor film of the present invention, in the step (ii), the Group Ia element and the Group Vb element may be supplied to the fourth thin film by sputtering using a sintered body containing at least the Group Ia element and the Group Vb element as a target or the Group Ia element and the Group Vb element may be supplied to the fourth thin film by evaporation using a sintered body containing at least the Group Ia element and the Group Vb element as an evaporation source. This allows a predetermined amount of the Group Ia element and the Group Vb element to be supplied with excellent reproducibility. Furthermore, this sintered body may contain at least one selected from the group consisting of lithium phosphate and sodium phosphate. These compounds enable the stable supply of a Group Ia element and a Group Vb element with favorable controllability.

The third method for manufacturing a semiconductor film of the present invention includes the step of: when forming a compound semiconductor containing a Group Ib element, a Group IIIb element and a Group VIb element, a Group Ia element and a Group Vb element concurrently are supplied thereto so as to form the semiconductor film having a composition in which the Group Ia element and the Group Vb element are added to the compound semiconductor with a chalcopyrite structure containing the Group Ib element, the Group IIIb element and the Group VIb element. With this method, a semiconductor film can be formed in which a Group Ia element and a Group Vb element are added to a compound semiconductor containing a Group Ib element, a Group IIIb element and a Group VIb element, and therefore a semiconductor film whose carrier density is controlled effectively can be provided.

The method for manufacturing a solar cell of the present invention includes the steps of: preparing a substrate; and providing a semiconductor film as a light-absorption layer on the substrate according to any one of the above-described semiconductor film manufacturing methods. Thereby, a light-absorption layer whose carrier density is controlled effectively can be provided, and therefore a solar cell having a high energy conversion efficiency can be provided.

As stated above, according to the semiconductor film and its manufacturing method of the present invention, a semiconductor film whose carrier density is controlled effectively can be provided. Furthermore, according to the solar cell and its manufacturing method of the present invention, a solar cell with a high energy conversion efficiency can be provided.

A number of preferred embodiments of the present invention will now be described by way of example only and with reference to the accompanying drawings, in which:
Fig. 1 is a cross-sectional view showing a solar cell of Embodiment 1 of the present invention.
Figs. 2A to C are cross-sectional views showing the steps in a method for manufacturing the solar cell of Embodiment 1 of the present invention.
Fig. 3 is a cross-sectional view showing another configuration of the solar cell according to Embodiment 1 of the present invention.
Fig. 4 is a cross-sectional view showing a solar cell of Embodiment 2 of the present invention.
Figs. 5A to C are cross-sectional views showing the steps in a method for manufacturing the solar cell of Embodiment 2 of the present invention.
Fig. 6 shows an X-ray diffraction pattern of a sample of Example 1 of the present invention.
Fig. 7 shows a relationship between the film thickness of sodium phosphate and the carrier density.
Fig. 8 shows a relationship between the film thickness of lithium phosphate and the carrier density, the film thickness being obtained by the conversion from the evaporation amount of the lithium phosphate.
Fig. 9 shows a relationship between the depth from the semiconductor film surface and the distribution of respective elements of Example 4 of the present invention.

The following describes embodiments of the present invention, with reference to the drawings. The present invention is not limited to the following embodiments.

### Embodiment 1

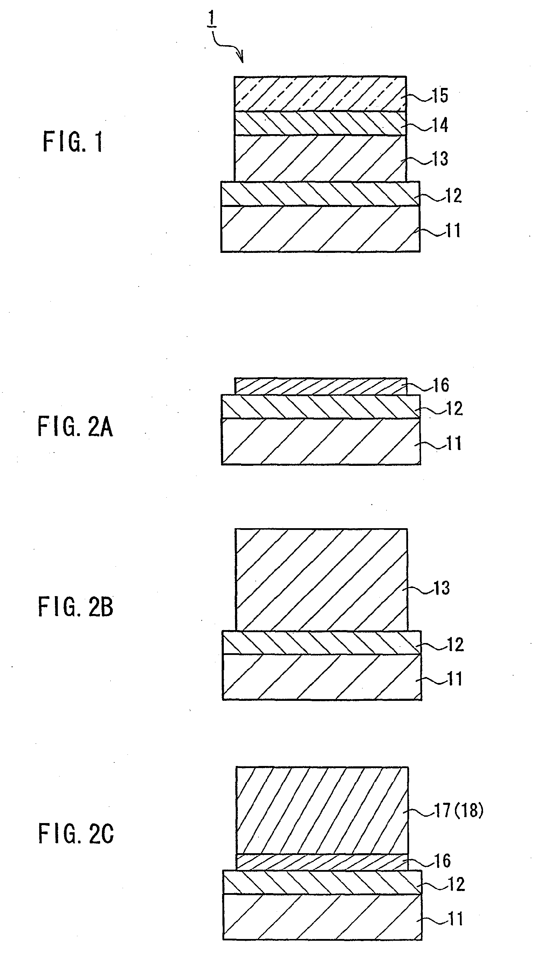

Fig. 1 is a cross-sectional view showing one embodiment of a solar cell of the present invention. As shown in Fig. 1, a solar cell 1 of the present embodiment is formed to include an electrode layer 12, a light-absorption layer 13, a window layer 14 and a transparent electrode layer 15 that are laminated in this stated order on a substrate 11.

As the substrate 11, a glass substrate, a metal substrate (stainless steel board, Ti board and the like) or a metal substrate coated with an insulation film can be used, for example.

The electrode layer 12 is formed of, for example, a metal thin film such as Mo.

As the window layer 14, Zn based compounds such as ZnO and Zn₁₋ₓMgₓO (0<x<1), In based compounds such as In₂O₃ and In₂S₃ or oxides such as Ga₂O₃ and Al₂O₃ can be used, for example.

As the transparent electrode layer 15, ITO and ZnO:Al or ZnO:Ga in which a Group III element such as Al or Ga is doped to ZnO, etc., can be used, for example.

The light-absorption layer 13 is a semiconductor layer made up of a semiconductor film having a composition in which a Group Ia element and a Group Vb element are added to a compound semiconductor having a chalcopyrite structure containing a Group Ib element, a Group IIIb element and a Group VIb element. As the Group Ib element, Cu preferably is used. As the Group IIIb element, at least one element selected from In and Ga preferably is used. As the Group VIb element, at least one element selected from Se and S preferably is used. Therefore, as a specific example of the compound semiconductor with a chalcopyrite structure containing a Group Ib element, a Group IIIb element and a Group VIb element, a suitable one includes CIS, CIGS or one obtained by replacing a part of Se in a compound semiconductor of these with S. As the added Group Ia element, at least one element selected from Li, Na and K preferably is used. As the Group Vb element, at least one element selected from N and P preferably is used.

This semiconductor layer preferably contains a 0.005 to 5 atom% of Group Ia element, more preferably 0.05 to 0.5 atom%. A content of the Group Vb element preferably ranges from 0.001 to 1 atom%, more preferably from 0.01 to 0.1 atom%.

In this semiconductor layer, the Group Ia element is doped to the compound semiconductor having a chalcopyrite structure containing the Group Ib element, the Group IIIb element and the Group VIb element, and therefore its crystal defects can be reduced. For instance, a defect in a Group VIb element such as Se is a n-type dopant, which functions as a donor, and therefore a reduction in this defect leads to an increase of the density of an acceptor that is a p-type dopant that tends to be cancelled out with the donor. Furthermore, since this semiconductor layer further includes the Group Vb element doped thereto, the density of the acceptor increases. This is because the Group Vb element is replaced with the Group VIb element in the chalcopyrite structured compound semiconductor so as to function as an acceptor. In this way, in the present embodiment, a Group Ia element and a Group Vb element both are doped to the semiconductor layer, whereby a reduction in crystal defects by virtue of the doping of the Group Ia element and the enhancement of the acceptor density by virtue of the doping of the Group Vb element can be realized concurrently, thus controlling a carrier density effectively. As a result, a solar cell provided with a light-absorption layer having a favorable carrier density can be realized.

One example of a method for manufacturing the solar cell 1 will be described below. Figs. 2A to C are cross-sectional views showing the steps in the method for manufacturing the solar cell of the present embodiment.

On a substrate 11, a conducting film that will be an electrode layer 12 is formed by sputtering or evaporation. Furthermore, on the electrode layer 12, a first thin film 16 containing a Group Ia element and a Group Vb element is formed (See Fig. 2A). The first thin film 16 may be formed of lithium phosphate, lithium nitrate, sodium phosphate, sodium nitrate, potassium phosphate or potassium nitrate, for example. The first thin film 16 can be formed, for example, using a sintered body containing at least the Group Ia element and the Group Vb element by sputtering or evaporation.

Next, while keeping a temperature of the substrate 11 at 300 to 600°C, a Group Ib element, a Group IIIb element and a Group VIb element are deposited on the first thin film 16 by sputtering or evaporation. In this step, the Group Ia element and the Group Vb element are doped from the first thin film 16, so that a semiconductor layer (light-absorption layer 13) having a composition in which the Group Ia element and the Group Vb element are added to a compound semiconductor having a chalcopyrite structure containing the Group Ib element, the Group IIIb element and the Group VIb element can be formed (See Fig. 2B).

As other methods for manufacturing such a semiconductor layer (light-absorption layer 13), the following are available: that is, a second thin film 17 (See Fig. 2C) containing a Group Ib element and a Group IIIb element may be formed on the first thin film 16 by sputtering, followed by a heat treatment of the first thin film 16 and the second thin film 17 in an atmosphere of a Group VIb element; and a third thin film 18 (See Fig. 2C) containing a Group Ib element, a Group IIIb element and a Group VIb element may be formed on the first thin film 16 by sputtering, followed by a heat treatment of the first thin film 16 and the third thin film 18. These methods also enable the formation of the semiconductor layer (light-absorption layer 13) having a composition in which the Group Ia element and the Group Vb element are added to a compound semiconductor having a chalcopyrite structure containing the Group Ib element, the Group IIIb element and the Group VIb element. Note here that, instead of the sputtering and evaporation, an electrodeposition method also can be used. The heat treatment in this step may be conducted, for example, by applying heat in the range of 400 to 600°C in an atmosphere of a H₂Se gas diluted at 1 to 5 % or in a Se vapor.

As stated above, the light-absorption layer 13 is formed, and thereafter a window layer 14 and a transparent electrode layer 15 are formed on the light-absorption layer 13 by sputtering or evaporation, whereby the solar cell 1 can be manufactured.

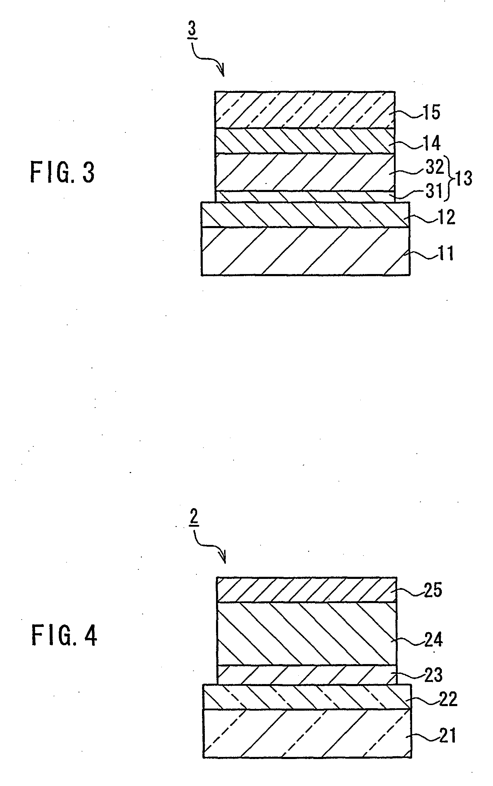

That is the explanation of the solar cell 1 according to Embodiment 1 of the present invention, but the present invention is not limited to this. For instance, in the step of the formation of the first thin film 16 on the electrode layer 12 of the above manufacturing method, the thickness of the first thin film 16 may be controlled so as to form a solar cell 3 as shown in Fig. 3, in which a light-absorption layer 13 includes a first light-absorption layer 31 disposed on the side of the electrode layer 12 and a second light-absorption layer 32 disposed so as to sandwich the first light-absorption layer 31 with the electrode layer 12. Note here that a content of atoms of the Group Ia element and the Group Vb element in the first light-absorption layer 31 is twice or more a content of atoms of the Group Ia element and the Group Vb element in the second light-absorption layer 32.

### Embodiment 2

Fig. 4 is a cross-sectional view showing another embodiment of a solar cell of the present invention. As shown in Fig. 4, a solar cell 2 of the present embodiment is formed to include a transparent electrode layer 22, a window layer 23, a light-absorption layer 24 and an electrode layer 25 that are laminated in this stated order on a transparent substrate 21.

As the transparent substrate 21, a glass substrate can be used, for example.

As the transparent electrode layer 22, ITO and ZnO:Al or ZnO:Ga in which a Group III element such as Al or Ga is doped to ZnO, etc., can be used, for example.

As the window layer 23, Zn based compounds such as ZnO and Zn₁₋ₓMgₓO (0<x<1), In based compounds such as In₂O₃ and In₂S₃ or oxides such as Ga₂O₃ and Al₂O₃ can be used, for example.

The light-absorption layer 24 is a semiconductor layer (semiconductor film) formed of the same materials and with the same manufacturing method as those of the light-absorption layer 13 described in Embodiment 1. Similarly to Embodiment 1, a content of atoms of the Group Ia element preferably ranges from 0.005 to 5 atom%, more preferably from 0.05 to 0.5 atom%. A content of the Group Vb element preferably ranges from 0.001 to 1 atom%, more preferably from 0.01 to 0.1 atom%.

The electrode layer 25 is formed of, for example, a metal thin film such as Mo.

Such a solar cell 2 can realize the same effects as those of the solar cell 1 of Embodiment 1.

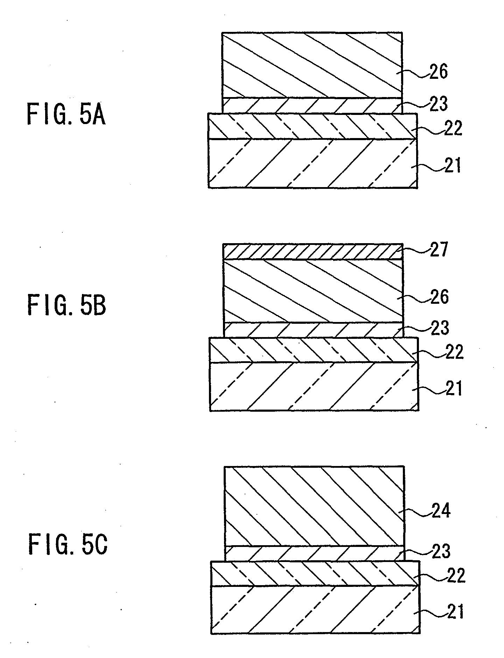

Next, one example of a method for manufacturing the solar cell 2 will be described below. Figs. 5A to C are cross-sectional views showing the steps in the method for manufacturing the solar cell 2 of the present embodiment.

On a transparent substrate 21, a transparent electrode layer 22 and a window layer 23 are formed in this stated order, and further a fourth thin film 26 containing a Group Ib element, a Group IIIb element and a Group VIb element is formed thereon (See Fig. 5A). As the Group Ib element, the Group IIIb element and the Group VIb element used for the formation of the fourth thin film 26, the same elements as those in Embodiment 1 may be used. The same methods as those in Embodiment 1, such as sputtering and evaporation, can be used.

Next, on the fourth thin film 26, a fifth thin film 27 containing at least a Group Ia element and a Group Vb element is formed (See Fig. 5B). The fifth thin film 27 is formed of the same materials and with the same manufacturing method as those of the first thin film 16 described in Embodiment 1. Thereafter, the fourth thin film 26 and the fifth thin film 27 are subjected to a heat treatment. The heat treatment in this step may be conducted by applying heat in the range of 200 to 500°C and in an atmosphere of an inert gas such as nitrogen or argon, or an atmosphere containing a Group VIb element such as H₂Se or a Se vapor, or in the air or a vacuum. During this heat treatment, the Group Ia element and the Group Vb element are doped from the fifth thin film 27 to the fourth thin film 26. As a result, a semiconductor layer (light-absorption layer 24) can be formed having a composition in which the Group Ia element and the Group Vb element are added to a compound semiconductor having a chalcopyrite structure containing the Group Ib element, the Group IIIb element and the Group VIb element (See Fig. 5C). As another method for manufacturing this semiconductor layer (light-absorption layer 24), while applying heat to the fourth thin film 26 shown in Fig. 5A up to a temperature of 200 to 500°C, a Group Ia element and a Group Vb element may be deposited on the fourth thin film 26 by sputtering or evaporation.

As stated above, the light-absorption layer 24 is formed, and thereafter an electrode layer 25 is formed on the light-absorption layer 24 by sputtering or evaporation, whereby the solar cell 2 can be manufactured.

### Embodiment 3

The following describes still another embodiment of the method for manufacturing a solar cell of the present invention. The manufacturing method of the present embodiment is different from the manufacturing methods described in Embodiment 1 and Embodiment 2 in the steps for manufacturing the light-absorption layers 13 and 24 of the solar cells 1 and 2 shown in Figs. 1 and 4. According to the manufacturing method of the present embodiment, when a Group Ib element, a Group IIIb element and a Group VIb element are supplied, a Group Ia element and a Group Vb element also are supplied concurrently so as to form a semiconductor layer functioning as the light-absorption layers 13 and 24.

As the Group Ib element, the Group IIIb element and the Group VIb element, the Group Ia element and the Group Vb element, the same materials as those described in Embodiment 1 may be used, for example. As a method for supplying the Group Ib element, the Group IIIb element and the Group VIb element, sputtering and evaporation may be used, for example. As a method for supplying the Group Ia element and the Group Vb element, a method of supplying them using a sintered body containing at least the Group Ia element and the Group Vb element by sputtering and evaporation may be used.

According to the above-stated method, a semiconductor layer (functioning as the light-absorption layer 13 or 24) can be formed having a composition in which a Group Ia element and a Group Vb element are added to a compound semiconductor having a chalcopyrite structure containing a Group Ib element, a Group IIIb element and a Group VIb element. Therefore, a solar cell having the same effects as those of Embodiment 1 or 2 can be manufactured.

### Examples

Hereinafter, the present invention will be explained more specifically by way of examples.

### Example 1

In Example 1, one example of a method for manufacturing the solar cell (a manufacturing method of the semiconductor film) described in Embodiment 1 will be explained.

In this example, a stainless steel board (thickness: 50 µm) was used as the substrate 11, and a Mo film (thickness: 0.4 µm) was used as the electrode layer 12. The Mo film was formed by sputtering using Mo as a target in an atmosphere of Ar gas.

Next, a sodium phosphate film was formed as the first thin film 16 to have a film thickness ranging from 10 nm to 50 nm. The sodium phosphate film was formed by high-frequency sputtering using a sintered body of sodium phosphate as a target in an atmosphere of Ar gas. In this step, the gas pressure was set at 0.5 Pa and the power applied was set at 1 kW.

Next, on the sodium phosphate film, a Group Ib element, a Group IIIb element and a Group VIb element were deposited (thickness; 1.5 µm) so as to form a semiconductor film. More specifically, vacuum evaporation was conducted, in which the evaporation of Cu, In , Ga and Se was conducted from individual evaporation sources. The temperature of the substrate during the evaporation was set at 550°C.

With this method, a sample was obtained in which the Mo film and the semiconductor film were laminated on the stainless steel board.

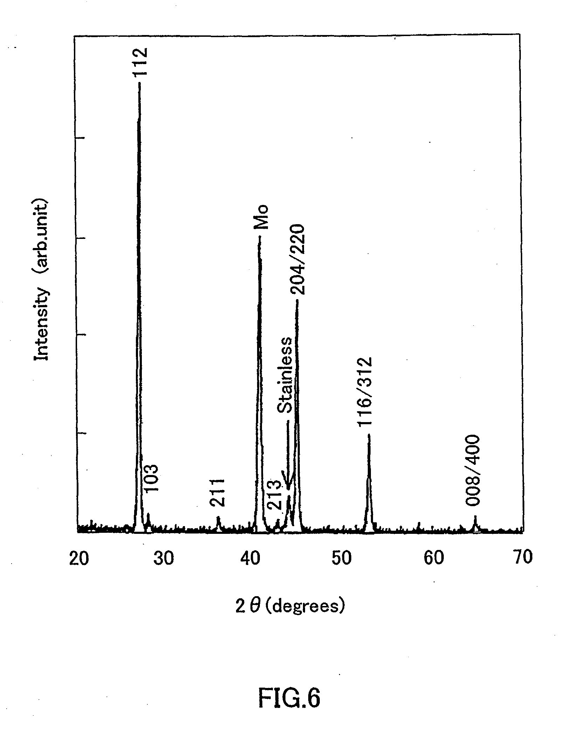

Fig. 6 shows an X-ray diffraction pattern of the thus manufactured sample (film thickness of sodium phosphate was 50 nm). On this X-ray diffraction pattern, diffraction peaks associated with the chalcopyrite structured CIGS film, the Mo film and the stainless steel only were observed, and other different peaks were not observed. From these results, it was confirmed that during the procedure for forming the film by depositing Cu, In Ga and Se, the elements contained in the sodium phosphate film were doped to this film, whereby the chalcopyrite structured semiconductor film was formed.

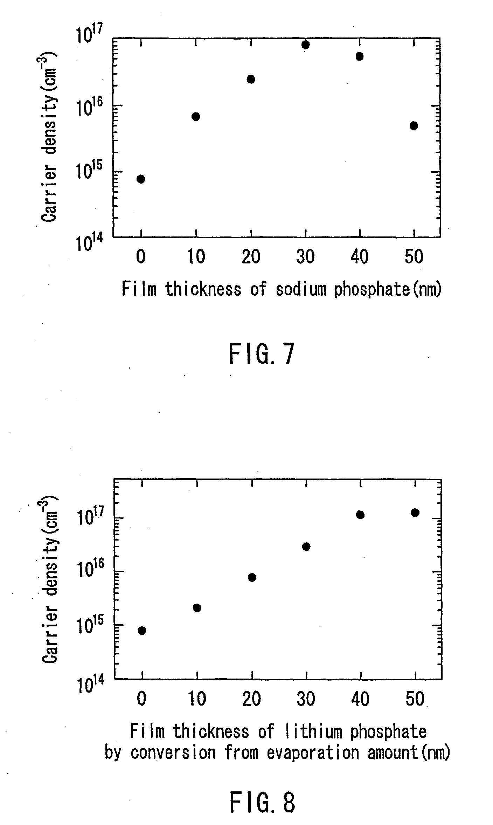

Next, a change in carrier density relative to the thickness of the sodium phosphate film was measured. A plurality of samples with sodium phosphate films having different film thicknesses ranging from 0 to 50 nm were prepared, and Al films were deposited on the respective surfaces of the semiconductor films of these samples so as to form a Schottky junction, and the carrier density was measured from capacity versus voltage characteristics. Fig. 7 shows the results. It was confirmed that when the film thickness of the sodium phosphate film was varied between 0 and 30 nm, the carrier density could be controlled within a range of 10¹⁵ to 10¹⁷/cm³. Note here that when the film thickness exceeded 30 nm, the carrier density decreased. Conceivably, this results from an increase in crystal defects due to an increase in the amount of doped Na. From the results, it was confirmed that the carrier density could be controlled by changing the film thickness of the sodium phosphate film.

### Example 2

In Example 2, one example of a method for manufacturing the solar cell (a manufacturing method of the semiconductor film) described in Embodiment 2 will be explained.

In this example, a glass substrate (thickness: 3 mm) was used as the transparent substrate 21, and an ITO film (thickness: 600 nm) was used as the transparent electrode layer 22. The ITO film was formed by sputtering using an ITO sintered body containing 10wt% of Sn in an atmosphere of a mixture gas of Ar gas and oxygen gas.

Next, a Zn_{0.9}Mg_{0.1}O film (thickness: 100 nm) was formed as the window layer 23. The Zn_{0.9}Mg_{0.1}O film was formed by high-frequency sputtering using a sintered body of Zn_{0.9}Mg_{0.1}O as a target in an atmosphere of Ar gas.

Next, on the Zn_{0.9}Mg_{0.1}O film, a CIGS film (thickness: 2 µm) was formed as the fourth thin film 26 (See Fig. 5A) containing a Group Ib element, a Group IIIb element and a Group VIb element. The CIGS film was formed by vacuum evaporation, in which the evaporation of Cu, In, Ga and Se was conducted from individual evaporation sources. The temperature of the substrate during the evaporation was kept at 550°C.

Next, on the CIGS film, a Group Ia element and a Group Vb element were deposited. They were formed by evaporation, in which a sintered body of lithium phosphate was used as an evaporation source containing the Group Ia element and the Group Vb element and this sintered body was heated in the range of 600 to 800°C. Furthermore, the temperature of the substrate during the evaporation was kept at 400°C, whereby Li and P were allowed to diffuse into the CIGS film so as to form a semiconductor film.

With the method, a sample was obtained in which the ITO film, the Zn_{0.9}Mg_{0.1}O film and the semiconductor film were formed on the glass substrate. On an X-ray diffraction pattern of this sample, diffraction peaks associated with the chalcopyrite structured CIGS film, the Zn_{0.9}Mg_{0.1}O film and the ITO film only were observed, and other different peaks were not observed. From these results, it was confirmed that the elements contained in the lithium phosphate were diffused into the CIGS film.

Furthermore, as for this sample, the distribution of respective elements of the semiconductor film was measured using a secondary ion-mass spectrography instrument (produced by ULVAC_PHI, INC. ADEPT1010, hereinafter called "SIMS"). According to the results, it was confirmed that a large amount of Li was distributed on the surface of the CIGS film. It was confirmed that a large amount of P was distributed on the surface of the CIGS film and the amount of P decreased with increasing proximity to the interface with the Zn_{0.9}Mg_{0.1}O film. Also from this measurement result by SIMS, it was confirmed that Li and P were diffused into the CIGS film.

Next, an Au film was evaporated onto the surface of the CIGS film of the sample so as to have an ohmic contact, whereby a pn junction made up of ITO/ Zn_{0.9}Mg_{0.1}O/CIGS was formed. Then, a carrier density was measured from the capacity versus voltage characteristics. Fig. 8 shows a change in carrier density relative to a film thickness of the lithium phosphate, the film thickness being obtained by the conversion from the evaporation amount of the lithium phosphate. In the range of the film thickness of the lithium phosphate from 0 to 40 nm, the carrier density increases substantially exponentially with the film thickness. In comparison with the case using the sodium phosphate of Example 1, there is no decrease in carrier density observed even at the film thickness of 50 nm. Conceivably, this is because the atomic radius of Li was small and therefore even when a large amount of Li was doped, there occurred less defects in the CIGS film.

From the above results, it was confirmed that the carrier density of the CIGS film could be controlled by changing the evaporation amount of lithium phosphate. Note here that lithium phosphate was used in this example, but the same results were obtained from the use of lithium nitrate.

### Example 3

In Example 3, one example of a method for manufacturing the solar cell (a manufacturing method of the semiconductor film) described in Embodiment 3 will be explained.

In this example, a stainless steel board (thickness: 50 µm) was used as the substrate 11, and a Mo film (thickness: 0.4 µm) was used as the electrode layer 12. The Mo film was formed by sputtering using Mo as a target in an atmosphere of Ar gas.

Next, Cu, In and S were supplied from individual evaporation sources by thermal evaporation, and at the same time sodium phosphate was evaporated within a temperature range of 600°C to 800°C so as to allow Na and P to be supplied. Furthermore, at this time, the temperature of the substrate was kept at 600°C so as to form a CIS film (CIS : Na, P film) of 2.5 µm in thickness to which Na and P were doped.

With this method, a sample was obtained in which the Mo film and the semiconductor film (CIS : Na, P film) were laminated on the stainless steel board.

On an X-ray diffraction pattern of this sample, diffraction peaks associated with the chalcopyrite structured CIS film, the Mo film and the stainless steel only were observed, and other different peaks were not observed. From these results, it was confirmed that sodium phosphate was diffused into the CIS film.

In addition, as for this sample, the distribution of respective elements of the semiconductor film was measured by SIMS. According to this result, it was confirmed that Na and P were distributed substantially uniformly in a direction of the depth of the CIS film. Also from this result, the diffusion of Na and P into the semiconductor film was confirmed.

Next, an Al film was evaporated onto the surface of the thus manufactured semiconductor film so as to form a Schottky junction, and the carrier density was measured from capacity versus voltage characteristics. A change in carrier density relative to the amount of evaporated sodium phosphate was substantially the same as that in Example 1. From this, it was confirmed that the carrier density could be controlled within a range of 10¹⁵ to 10¹⁷/cm³ by changing the evaporation amount of sodium phosphate.

### Example 4

In Example 4, one example of the solar cell 1 of Embodiment 1 will be explained.

As the substrate 11, a stainless steel board (thickness: 50 µm) coated with an Al₂O₃ film serving as an insulation layer was used. As the electrode layer 12, a Mo film (thickness: 0.4 µm) was formed.

The light-absorption layer 13 was formed of a semiconductor film (CIGS : Na, P film) of 2.5 µm in thickness, in which Na and P were doped into a CIGS film. The specific method for manufacturing this semiconductor film was the same as that in Example 1. In the present example, the film thickness of a sodium phosphate film was 20 nm.

Next, a Zn₁₋ₓMgₓO film was formed as the window layer 14, on which an ITO film was formed as the transparent window layer 15. The manufacturing methods and the film thicknesses of the Zn₁₋ₓMgₓO film and the ITO film were the same as those in Example 2.

After the formation of the ITO film, annealing was conducted thereto at 250°C for 10 minutes in an atmosphere of N₂. This enabled damages due to sputtering on the surface of the CIGS film, which occurred during the formation of the Zn₁₋ₓMgₓO film, to recover. With the above method, the solar cell of the present example was manufactured.

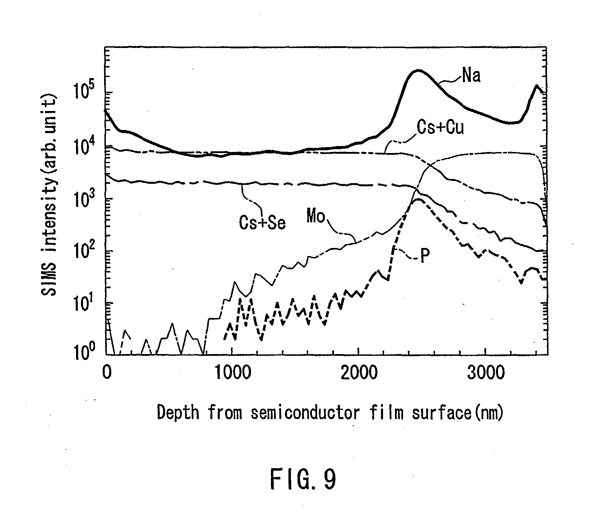

Fig. 9 shows the measurement result by SIMS of the distribution of respective elements of the semiconductor film (light-absorption layer 13) included in the thus manufactured solar cell of Example 4. In Fig. 9, the vertical axis represents a SIMS intensity and the horizontal axis represents a depth from the semiconductor film surface. As shown in Fig. 9, it was confirmed that, in the semiconductor film, a large amount of Na (solid line) was distributed closer to the interface with the Mo film (electrode layer 12) (2,300 to 2,500 nm on the horizontal axis of Fig. 9) and on the surface of the semiconductor film. It was also confirmed that a large amount of P (alternate long and short dashed line) was distributed closer to the interface with the Mo film and the amount of P decreased with increasing proximity to the surface of the semiconductor film. Furthermore, the semiconductor film in the vicinity of the interface with the Mo film (2,300 to 2,500 nm on the horizontal axis of Fig. 9) indicated a higher SIMS intensity for both of Na and P that were twice or more (which means twice or more contents of atoms) those of the semiconductor film at the other portions. From these results, it was confirmed that the semiconductor film (light-absorption layer 13) included in the solar cell of Example 4 was made up of the first light absorption layer 31 (See Fig. 3) disposed on the side of the Mo film and the second light-absorption layer 32 disposed so as to sandwich the first light-absorption layer 31 with the Mo film. Furthermore, it was confirmed that the elements other than Na and P were distributed uniformly in the film. Note here that a Na concentration in the semiconductor film included in the solar cell of Example 4 ranged from 0.005 to 5 atom% and a P concentration ranged from 0.001 to 1 atom%.

### Example 5

In Example 5, one example of the solar cell of Embodiment 3 will be explained.

The solar cell of Example 5 was manufactured in a similar manner to the above-described Example 4 except for the method for forming the light-absorption layer. Herein, the light-absorption layer 13 of the solar cell of Example 5 was formed of a semiconductor film (CIGS : Na, P film) of 2.5 µm in thickness, in which Na and P were doped into a CIGS film. This semiconductor film was formed by supplying Cu, In, Ga and Se from individual evaporation sources by thermal evaporation and concurrently by evaporating sodium phosphate in a temperature range of 600 to 800°C so as to allow Na and P to be supplied.

As a comparative example, another solar cell was manufactured, in which a sodium fluoride film (film thickness: 20 nm) was formed instead of the sodium phosphate film. That is, the solar cell as the comparative example was formed by allowing Na only to be doped into the CIGS film. Note here that the configuration other than the sodium fluoride film of the solar cell as the comparative example was the same as that of the solar cell of Example 4.

The properties of the solar cells of Examples 4 and 5 and the solar cell as the comparative example were measured with pseudo sunlight (air mass (AM): 1.5, 100 mW/cm²) using SOLAR SIMULATOR (produced by Wacom Electric Co., Ltd. WXS-130S-10). An open circuit voltage of the solar cell as the comparative example was 0.52 V, whereas open circuit voltages of the solar cells of Examples 4 and 5 increased to 0.63 V and 0.60 V, respectively. From these, it was confirmed that the use of the CIGS film with Na and P doped thereto as a light-absorption layer enabled a further increase in carrier density, which means the enhancement of an open circuit voltage, as compared with the CIGS film with Na only doped thereto from sodium fluoride as a light-absorption layer.

Furthermore, short-circuit current densities of the solar cells of Example 5 and the comparative example both were 32 mA/cm², whereas a short-circuit current density of the solar cell of Example 4 increased to 34 mA/cm². Conceivably, this resulted from the atom content of Na and P in the first light-absorption layer 31 of the solar cell of Example 4 being larger than the atom content of Na and P in the second light-absorption layer 32, thus leading to a decrease in recombination of carriers.

From these results, it was found that the doping of a Group Ia element and a Group Vb element into a CIGS film used as a light-absorption layer enabled an increase in carrier density of the CIGS film, which means an enhancement of an open circuit voltage, thus realizing a high energy conversion efficiency.

According to the semiconductor film and the manufacturing method of the same of the present invention, a carrier density can be controlled effectively, and therefore they can be used favorably for a solar cell required to have a high energy conversion efficiency, a light-emitting diode required to have a high luminous efficiency and the like. The solar cell and the manufacturing method of the same of the present invention are applicable to a solar cell required to have a high energy conversion efficiency.

## Claims

1. A semiconductor film, comprising a composition in which a Group Ia element and a Group Vb element are added to a compound semiconductor with a chalcopyrite structure comprising a Group Ib element, a Group IIIb element and a Group VIb element.

2. The semiconductor film according to claim 1, wherein a content of atoms of the Group Ia element in the semiconductor film ranges from 0.005 to 5 atom%, and a content of atoms of the Group Vb element in the semiconductor film ranges from 0.001 to 1 atom%.

3. The semiconductor film according to claim 1 or 2, wherein the Group Ia element is at least one element selected from the group consisting of Li, Na and K.

4. The semiconductor film according to claim 1, 2 or 3, wherein the Group Vb element is at least one element selected from the group consisting of N and P.

5. The semiconductor film according to claim 1, 2, 3 or 4,
wherein the Group Ib element is Cu,
the Group IIIb element is at least one element selected from the group consisting of In and Ga, and
the Group VIb element is at least one element selected from the group consisting of Se and S.

6. A solar cell, comprising:
a substrate; and
the semiconductor film according to any one of claims 1 to 5 that is provided on the substrate as a light-absorption layer.

7. The solar cell according to claim 6, further comprising an electrode layer that is provided on at least one of an upper surface and a lower surface of the light-absorption layer,
wherein the light-absorption layer comprises a first light-absorption layer disposed on a side of the electrode layer and a second light-absorption layer disposed so as to sandwich the first light-absorption layer with the electrode layer, and
a content of atoms of a Group Ia element and a Group Vb element in the first light-absorption layer is twice or more a content of atoms of a Group Ia element and a Group Vb element in the second light-absorption layer.

8. The solar cell according to claim 7, wherein the first light-absorption layer has a film thickness of 10 to 300 nm.

9. A method for manufacturing a semiconductor film, comprising the steps of:
(i) forming a first thin film comprising a Group Ia element and a Group Vb element; and
(ii) supplying a Group Ib element, a Group IIIb element and a Group VIb element on the first thin film so as to form the semiconductor film having a composition in which the Group Ia element and the Group Vb element are added to a compound semiconductor with a chalcopyrite structure comprising the Group Ib element, the Group IIIb element and the Group VIb element.

10. The method for manufacturing a semiconductor film according to claim 9, wherein the step (ii) comprises a step of forming the semiconductor film by depositing the Group Ib element, the Group IIIb element and the Group VIb element on the first thin film, while applying heat to the first thin film.

11. The method for manufacturing a semiconductor film according to claim 9, wherein the step (ii) comprises steps of:
(ii-A) forming a second thin film comprising the Group Ib element and the Group IIIb element on the first thin film; and
(ii-B) conducting a heat treatment on the first thin film and the second thin film in an atmosphere comprising the Group VIb element so as to form the semiconductor film.

12. The method for manufacturing a semiconductor film according to claim 9, wherein the step (ii) comprises steps of:
(ii-a) forming a third thin film comprising the Group Ib element, the Group IIIb element and the Group VIb element on the first thin film, and
(ii-b) conducting a heat treatment on the first thin film and the third thin film so as to form the semiconductor film.

13. The method for manufacturing a semiconductor film according to any one of claims 9 to 12, wherein the first thin film further comprises a Group VIb element.

14. The method for manufacturing a semiconductor film according to any one of claims 9 to 13, wherein the step (i) comprises a step of forming the first thin film by sputtering or evaporation using a sintered body comprising at least the Group Ia element and the Group Vb element as a target or an evaporation source.

15. The method for manufacturing a semiconductor film according to claim 14, wherein the sintered body comprises at least one selected from the group consisting of lithium phosphate and sodium phosphate.

16. A method for manufacturing a semiconductor film, comprising the steps of:
(i) forming a fourth thin film comprising a Group Ib element, a Group IIIb element and a Group VIb element; and
(ii) supplying a Group Ia element and a Group Vb element on the fourth thin film so as to form the semiconductor film having a composition in which the Group Ia element and the Group Vb element are added to a compound semiconductor with a chalcopyrite structure comprising the Group Ib element, the Group IIIb element and the Group VIb element.

17. The method for manufacturing a semiconductor film according to claim 16, wherein the step (ii) comprises a step of depositing the Group Ia element and the Group Vb element on the fourth thin film, while applying heat to the fourth thin film so as to form the semiconductor film.

18. The method for manufacturing a semiconductor film according to claim 16, wherein the step (ii) comprises the steps of:
(ii-A) forming a fifth thin film comprising the Group Ia element and the Group Vb element on the fourth thin film; and
(ii-B) conducting a heat treatment on the fourth thin film and the fifth thin film so as to form the semiconductor film.

19. The method for manufacturing a semiconductor film according to claim 18, wherein the fifth thin film further comprises a Group VIb element.

20. The method for manufacturing a semiconductor film according to claim 16, wherein, in the step (ii), the Group Ia element and the Group Vb element are supplied to the fourth thin film by sputtering or evaporation using a sintered body comprising at least the Group Ia element and the Group Vb element as a target or an evaporation source.

21. The method for manufacturing a semiconductor film according to claim 20, wherein the sintered body comprises at least one selected from the group consisting of lithium phosphate and sodium phosphate.

22. A method for manufacturing a semiconductor film, comprising the step of: when forming a compound semiconductor comprising a Group Ib element, a Group IIIb element and a Group VIb element, supplying a Group Ia element and a Group Vb element concurrently thereto so as to form the semiconductor film having a composition in which the Group Ia element and the Group Vb element are added to the compound semiconductor with a chalcopyrite structure comprising the Group Ib element, the Group IIIb element and the Group VIb element.

23. A method for manufacturing a solar cell, comprising the steps of:
preparing a substrate; and
providing a semiconductor film as a light-absorption layer on the substrate according to the semiconductor film manufacturing method according to any one of claims 9 to 22.
